# EUROPÄISCHE PATENTSCHRIFT

(11) **EP 2 959 033 B1**
(45) Veröffentlichungstag und Bekanntmachung des Hinweises auf die Patenterteilung: **13.09.2017**
(21) Anmeldenummer: 14705283.1
(22) Anmeldetag: 10.02.2014
(51) Int. Cl.: C23C 16/00, C23C 16/02, C23C 16/26, C23C 16/50, C23C 16/455

(54) **DLC BESCHICHTUNG MIT EINLAUFSCHICHT**
DLC COATING WITH AN ABRADABLE LAYER
REVÊTEMENT DLC COMPRENANT UNE COUCHE D'USURE

(30) Priorität: 21.02.2013 DE 102013002911; 25.04.2013 DE 102013007146
(43) Veröffentlichungstag der Anmeldung: 30.12.2015
(73) Patentinhaber: Oerlikon Surface Solutions AG, Pfäffikon, 8808 Pfäffikon (CH)
(72) Erfinder: GUIMOND, Sebastien, 9000 St. Gallen (CH); WURZER, Manfred, CH-9300 Wittenbach (CH); WIDOWITZ, Franz, A-6800 Feldkirch (AT)
(74) Vertreter: Misselhorn, Hein-Martin
(86) Internationale Anmeldenummer: PCT/EP2014/000425
(87) Internationale Veröffentlichungsnummer: WO 2014/127902

(56) Entgegenhaltungen:
- WO-A1-00/47290
- US-A- 5 900 289
- STUBER M ET AL: "Graded layer design for stress-reduced and strongly adherent superhard amorphous carbon films", SURFACE AND COATINGS TECHNOLOGY, ELSEVIER, AMSTERDAM, NL, Bd. 116-119, 1. September 1999 (1999-09-01), Seiten 591-598, XP027346036, ISSN: 0257-8972 [gefunden am 1999-09-01]
- ZHANG G F ET AL: "Influence of deposition parameters on the refractive index and growth rate of diamond-like carbon films", SURFACE AND COATINGS TECHNOLOGY, ELSEVIER, AMSTERDAM, NL, Bd. 64, Nr. 2, 1. Mai 1994 (1994-05-01), Seiten 127-130, XP026502514, ISSN: 0257-8972, DOI: 10.1016/S0257-8972(09)90013-5 [gefunden am 1994-05-01]

## Beschreibung

Die vorliegende Erfindung bezieht sich auf eine Methode zu Herstellung einer Verschleissschutzschicht mit dicker Einlaufschicht.

### State of the art

Bei Bauteilen mit gleitenden Oberflächen besteht ein grosses Bedürfnis nach harten Oberflächen, welche jedoch als äusserste Schicht eine Einlaufschicht aufweisen,so dass der gleitende Gegenkörper zunächst in der Lage ist,die Einlaufschicht zumindest teilweise abzutragen und so eine Anpassung an seine eigene Geometrie zu erzielen. Als Gleitschichten ist es bekannt, DLC-Schichten einzusetzen und diese mit einer weicheren Schicht zu überziehen, so dass diese weichere Schicht als Einlaufschicht wirksam wird. Nachteilig hierbei ist allerdings, dass auf ein anderes Schichtmaterial übergegangen werden muss. Dies stellt erhöhte Anforderungen an die Beschichtungsanlage und das durchzuführende Beschichtungsverfahren. US 5 900 289 zeigt ein DLC Schichtsystem,wobei die obere Schicht ein Silizium-Gehaltsgradient zeigt.

Struber et Al, in "Graded layer design for stress-reduced and strongly adherent superhard amorphous carbon films", surface and coatings technology, 116-119 (1999) 591-598 beschreibt ein DLC Schichtsystem, wobei die obere Schicht ein Härtegradient zeigt und wobei die untere Schicht aus amorphem Kohlenstoff ist. Es ist daher die Aufgabe der vorliegenden Erfindung , eine harte Oberflächenbeschichtung anzugeben mit weicher Einlaufschicht, wobei die Schichtmaterialien der harten Beschichtung und der weichen Einlaufschicht im Wesentlichen, was die chemischen Elemente und deren Konzentration betrifft,gleich ist.

Dies wird dadurch erreicht, dass auf eine DLC-Schicht eine Gradientenschicht mit abnehmender Dichte und dadurch mit abnehmender Härte realisiert wird, so,wie im Anspruch 1 beschrieben. Bei genügender Dicke der Gradientenschicht wird hierdurch eine effiziente Einlaufschicht erzeugt.

Dabei ist klar, dass aufgrund der geringeren und abnehmenden Dichte der Gradientenschicht dies zu einer Reduktion der Gesamthärte der Schicht führt. In einer bevorzugten Ausführungsform wird der Gradient so realisiert, dass die Gesamthärte der Schicht nicht geringer als 15 GPa ist.

Gemäss einer weiteren bevorzugten Ausführungsform der vorliegenden Erfindung hat die DLC-Schicht eine Härte, welche nicht geringer als 1500HV oder 15 GPa ist, bevorzugterweise nicht geringer als 18 GPa ist und noch bevorzugter nicht geringer als 20 GPa. ist.

Gemäss einer weiteren bevorzugten Ausführungsform der vorliegenden Erfindung gibt es innerhalb der Gradientenschichtdicke keinen Bereich,der eine geringere Härte als 600 HV oder 6 GPa aufweisst, vorzugsweise nicht geringer als 8 GPa.

Gemäss einer weiteren Ausführungsform der vorliegenden Erfindung ist die Dicke der DLC-Schicht nicht geringer als 0.5µm.

Gemäss einer weiteren Ausführungsform der vorliegenden Erfindung beträgt die Dicke der Gradientenschicht nicht weniger als 300 nm.

Eine Beschichtung gemäss der vorliegenden Erfindung ist mittels Plasmaunterstützten CVD Prozessen,so,wie im Anspruch 3 beschrieben,hergestellt. Die Beschichtung entsprechend der vorliegenden Erfindung hat unter anderem folgende Vorteile:
Die DLC-Schicht bleibt hart genug,um Verschleissschutz zu gewährleisten.

Auf Substraten mit erhöhter Rauigkeit kann es sogar zu einer Erhöhung der Verschleissbeständigkeit der Gradientenschicht kommen, da die Bereiche zwischen den Substratspitzen geschützt sind.

Die Herstellung der Gradientenschicht kann auf dem herkömmlichen Prozess für die Herstellung der DLC-Schicht beruhen. Es wird keine zusätzliche Ausrüstung oder zusätzliche Gase benötigt.

Die Erfindung wird nun anhand einer Prozessbeschreibung im Detail und beispielhaft erläutert.
Figur 1 zeigt die Wasserstoffkonzentration für verschiedene DLC Proben im Vergleich zu einer Referenz.
Figur 2 zeigt den Vergleich einer DLC Probe mit und einer ohne Gradient in Bezug auf Verschleiss.

Die Substrate wurden in einer Vakuumkammer mittels einer plasmageschützten CVD Methode hergestellt, wobei eine Kombination aus Acetylen und Argon als Prozessgas verwendet wird. Das Prozessgas wurde in der Kammer mittels eines Plasmas ionisiert, welches über eine Niedervoltbogenentladung erzeugt wurde. Zusätzlich wurde während des Beschichtungsprozesses ein Substratbias an die Substrate angelegt.

Zur Beschichtung der DLC-Schicht wurde der Substratbias auf einem konstanten Wert von 900 V gehalten. Die DLC-Beschichtung nahm 80 Minuten in Anspruch. Zur Beschichtung der Gradientenschicht wurde der Substratbias kontinuierlich von 900 V auf 50 V reduziert. Nach Ablauf von 40 Minuten war ein Substratbias von 50 V erreicht. Abgesehen vom Substratbias wurden die anderen Beschichtungsparameter während der gesamten Beschichtung konstant gehalten. Es wird jedoch der Niedervoltbogen- Entladungsstrom kontinuierlich erhöht,um der mit der Reduktion des Substratbias einhergehenden Abnahme des Substratstroms entgegen zu wirken. Durch diese kontinuierliche Reduktion des Substratbias erfolgte eine kontinuierliche Reduktion der Schichtdichte, die wiederum eine Reduktion der Schichthärte zur Folge hatte.

Im Ergebnis, war die Gradientenschicht 0.7 µm dick. Die für das Gesamtsystem (DLC-Schicht und Gradientenschicht) auf einem Fischerscope mit 10mN Last gemessene Härte betrug 18GPa. Das Schichtsystem zeigte eine exzellente Verschleissbeständigkeit.

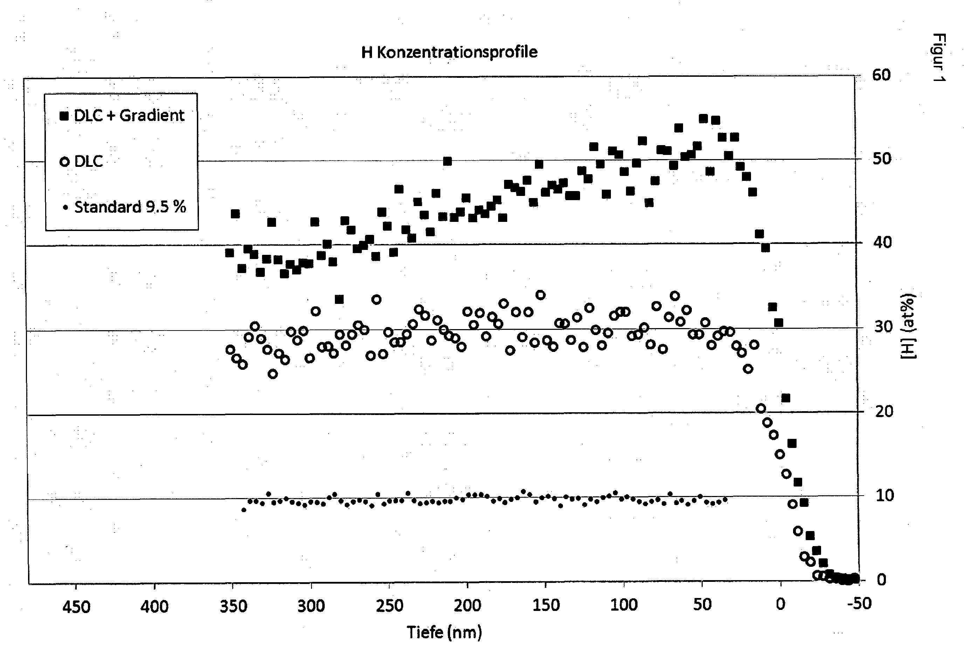

Ein Tiefenprofil der Wasserstoff Atomkonzentration ([H]) wurde mit 2 MeV He ERDA (Elastic Recoil Detection Analysis) für 2 DLC Proben ermittelt: eine mit und eine ohne Gradient. Zur Berechnung der Daten wurde ein Standard mit 9.5 at% H (Glimmer) als Referenz gemessen und der Energieverlust (Bremsvermögen) der Alphateilchen in den DLC-Schichten und im Standard wurde mit dem SRIM Programm (www.srim.org) bestimmt. Die Beschichtung der DLC Schicht ohne Gradient erfolgte mit einem konstanten Substratbias von 900 V und nahm 80 Minuten in Anspruch (Schichtdicke ∼ 1 µm). Zur Beschichtung der DLC Schicht mit Gradient wurde der Substratbias kontinuierlich von 900 V auf 50 V reduziert. Dieser Schritt nahm 80 Minuten in Anspruch und resultierte in einer Gradientenschichtdicke von 1.5 µm. Die Resultate sind in Figur 1 dargestellt. Diese Methode erlaubt es, bis in eine Tiefe von etwa 350 nm zu messen. Die Oberfläche ist im Profil rechts (0) und die Tiefenskala läuft nach links. Die Resultate zeigen, dass die Wasserstoffatomkonzentration zu der Gradientenoberfläche hin zunimmt. Bei der DLC Probe ohne Gradient bleibt die Wassserstoffatomkonzentration hingegen konstant.

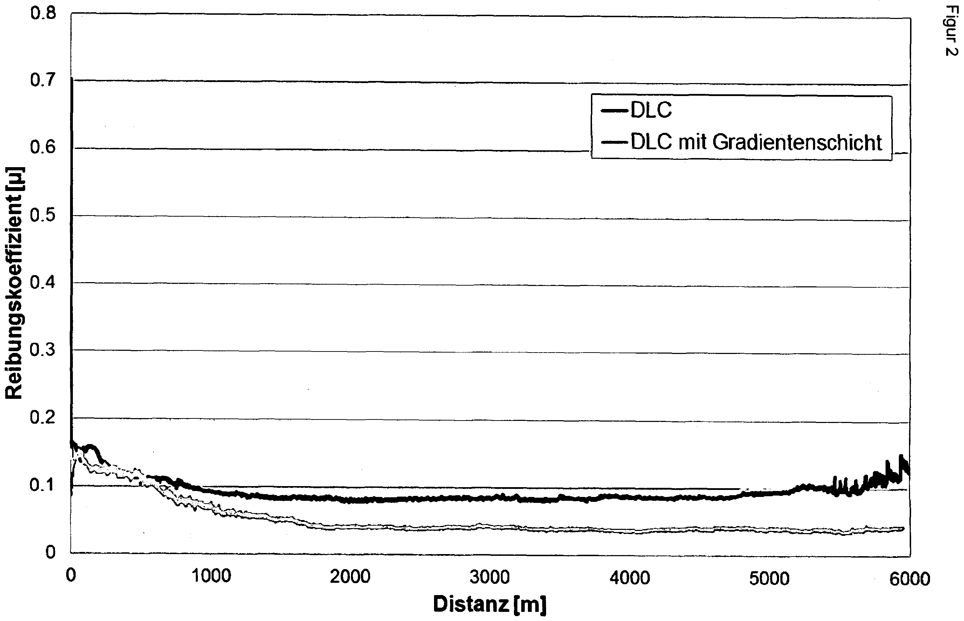

Die Reibung des DLC mit Gradientenschicht wurde mit dem Pin on disk Test (Pin-on-dick Tribometer, CSM Instruments) untersucht und mit DLC (ohne Gradientenschicht) verglichen. Das Substrat war das gleiche für beide Untersuchungen (polierte Stahlscheibe). Der Test wurde in Luft bei einer Temperatur von 22°C und 43% relative Feuchtigkeit durchgeführt. Die Proben wurden gegen eine 100Cr6 Stahlkugel mit 3 mm Durchmesser abgerieben. Die Stahlkugel diente als statischer Reibungspartner und die beschichtete Probe wurde unter diesen gedreht (Radius 6 mm, Geschwindigkeit 30 cm/s). Eine 30 N Last wurde auf die Kugel angelegt. Die repräsentativen Reibungskoeffizienten für die ersten 50 Meter und bis nach 6000 Meter sind in den Abbildungen 1 und 2 für beide Beschichtungen dargestellt. Es ist festzustellen, dass der Reibungskoeffizient für DLC mit Gradientenschicht deutlich geringer als für DLC allein ist, insbesondere in der Anfangsphase. Die Untersuchung der abgeriebenen Oberflächen nach dem Test zeigt auch generell deutlich weniger Schicht- und Gegenkörperverchleiss für DLC mit Gradientenschicht als für DLC allein (Breite der Abriebspur auf der Beschichtung 260 µm vs 450 µm, Durchmesser der abgeriebenen Fläche auf der Kugel 300 µm vs 600 µm).

Auch mit ersten Feldversuchen in der konkreten Anwendung konnte das bessere Einlaufverhalten des DLC mit Gradientenschicht nachgewiesen werden.

## Patentansprüche

1. Hartstoffschicht auf einer Komponente, wobei die Hartstoffschicht eine DLC-Schicht mit einer Härte von mindestens 10 GPa umfasst, **dadurch gekennzeichnet, dass** auf der diamantähnlichen Kohlenstoffschicht eine mindestens 300 nm dicke DLC Gradientenschicht vorgesehen ist, wobei die DLC Gradientenschicht mit abnehmender Dichte und dadurch mit abnehmender Härte realisiert ist, und wobei sich die DLC Gradientenschicht von der DLC Schicht in Bezug auf die umfassenden chemischen Elemente nicht unterscheidet.

2. Hartstoffschicht nach Anspruch 1, **dadurch gekennzeichnet, dass** sich die chemische Zusammensetzung der Gradientenschicht von der chemischen Zusammensetzung der DLC-Schicht im Wesentlichen lediglich im Wasserstoffgehalt unterscheidet.

3. Verfahren zur Herstellung einer verschleissfesten Oberfläche umfassend die Schritte:
- Beladung einer Beschichtungskammer mit zu beschichtenden Substraten,
- Abpumpen der Beschichtungskammer und Einlassen von Prozessgas umfassend Acetylen und Argon,
- Aufbau eines Plasmas vorzugsweise mittels Niedervoltbogenentladung,
- Anlegen eines Substratbias an die zu beschichtenden Substrate,
**dadurch gekennzeichnet, dass** zur Ablegung einer DLC-Schicht zunächst ein betragsmässig hoher Substratbias angelegt wird und zur anschliessenden Beschichtung einer DLC Gradientenschicht der Substratbias verringert, vorzugsweise kontinuierlich und/oder mit einer Vielzahl von kleinen Reduktionsschritten, wobei abgesehen vom Substratbias die anderen Beschichtungsparameter während der gesamten Beschichtung konstant gehalten werden, so dass sich die DLC Gradientenschicht von der DLC Schicht in Bezug auf die umfassenden chemischen Elemente nicht unterscheidet,und wobei durch diese Reduktion des Substratbias eine Reduktion der Schichtdichte entsteht, die wiederum eine Reduktion der Schichthärte der DLC Gradientenschicht zur Folge hat.

4. Verfahren nach Anspruch 3, **dadurch gekennzeichnet, dass** gleichzeitig zur Verringerung des Substratbias der Niedervoltbogen- Entladungsstrom kontinuierlich einhergehenden erhöht wird, um der mit der Reduktion des Substratbias einhergehenden Abnahme der Plasmadichte entgegen zu wirken.

## Claims

1. A hard material layer on a component, wherein the hard material layer comprises a DLC layer with a hardness of at least 10 GPa, **characterized in that** a DLC gradient layer with a thickness of at least 300 nm is provided on the diamond-like carbon layer, wherein the DLC gradient layer is realized with a decreasing density and thus, with a decreasing hardness, and wherein the DLC gradient layer does not differ from the DLC layer with respect to the chemical elements comprised.

2. The hard material layer according to claim 1, **characterized in that** the chemical composition of the gradient layer differs from the chemical composition of the DLC layer substantially only with regard to the hydrogen content.

3. A method for manufacturing a wear-resistant surface, comprising the steps of:
- loading a coating chamber with substrates to be coated,
- pumping out the coating chamber and introducing a process gas including acetylene and argon,
- generating a plasma, preferably by means of low-voltage arc discharge,
- applying a substrate bias to the substrates to be coated,
**characterized in that**, in order to deposit a DLC layer, first a quantitatively high substrate bias is applied and for the subsequent coating of a DLC gradient layer, the substrate bias is reduced, preferably continuously and/or with a plurality of small reduction steps, wherein, with the exception of the substrate bias, the other coating parameters are kept constant during the entire coating process, so that the DLC gradient layer does not differ from the DLC layer with regard to the chemical elements comprised, and wherein this reduction of the substrate bias produces a reduction in the layer density, which in turn causes a reduction in the layer hardness of the DLC gradient layer.

4. The method according to claim 3, **characterized in that** the low-voltage discharge current is continuously increased concurrently with the reduction of the substrate bias, in order to counteract the decrease in plasma density that accompanies the reduction of the substrate bias.

## Revendications

1. Couche en matériau dur sur un composant, la couche en matériau dur comprenant une couche DLC ("Diamant Like Carbon") d'une dureté d'au moins 10 GPa, **caractérisée en ce que** sur la couche de carbone semblable au diamant est prévue une couche à gradient DLC d'une épaisseur d'au moins 300 nm, la couche à gradient DLC étant réalisée avec une densité décroissante et donc avec une dureté décroissante, et la couche à gradient DLC ne se distingue pas de la couche DLC en ce qui concerne les éléments chimiques inclus.

2. Couche en matériau dur selon la revendication 1, **caractérisée en ce que** la composition chimique de la couche à gradient se distingue de la composition chimique de la couche DLC sensiblement par la seule teneur en hydrogène.

3. Procédé de réalisation d'une surface résistante à l'usure, comprenant les étapes suivantes consistant à :
- charger une chambre de revêtement avec des substrats à revêtir,
- évacuer la chambre de revêtement et introduire un gaz de processus comprenant de l'acétylène et de l'argon,
- constituer un plasma de préférence au moyen d'une décharge en arc à basse tension,
- appliquer une polarisation aux substrats à revêtir,
**caractérisé en ce que**
pour poser une couche DLC, on applique tout d'abord une polarisation d'une valeur élevée, et pour revêtir ensuite une couche à gradient DLC, on réduit la polarisation, de préférence en continu et/ou avec une multitude de petits pas de réduction, et, mise à part la polarisation, on maintient constants les autres paramètres de revêtement pendant toute l'opération de revêtement, de sorte que la couche à gradient DLC ne se distingue pas de la couche DLC en ce qui concerne les éléments chimiques inclus, et grâce à cette réduction de la polarisation, il résulte une réduction de la densité de couche qui provoque à son tour une réduction de la dureté de couche de la couche à gradient DLC.

4. Procédé selon la revendication 3, **caractérisé en ce que** simultanément avec la réduction de la polarisation des substrats, on augmente en continu le courant de décharge en arc à basse tension, afin de contrecarrer la diminution de la densité de plasma qui accompagne la réduction de la polarisation.
